# EUROPEAN PATENT APPLICATION

(11) **EP 4 847 576 A1**
(43) Date of publication of application: **02.12.2026**
(21) Application number: 25744945.4
(22) Date of filing: 17.01.2025
(51) Int. Cl.: C09J 201/00, C09J 9/02, C09J 11/04, H01B 1/20, H01B 5/16, H05K 3/36

(54) **ANISOTROPIC CONDUCTIVE ADHESIVE, AND CONNECTION STRUCTURE**

(30) Priority: 24.01.2024 JP 2024008455; 09.01.2025 JP 2025003316
(71) Applicant: Dexerials Corporation, Shimotsuke-shi, Tochigi 323-0194 (JP)
(72) Inventor: NAMIKI, Hidetsugu, Shimotsuke-shi, Tochigi 323-0194 (JP); SHIMADA, Kazuto, Shimotsuke-shi, Tochigi 323-0194 (JP); HAYASHI, Naoki, Shimotsuke-shi, Tochigi 323-0194 (JP)
(74) Representative: Fleuchaus & Gallo Partnerschaft mbB
(86) International application number: PCT/JP2025/001335
(87) International publication number: WO 2025/159016

(57) **Abstract**

An anisotropic conductive adhesive includes: a resin including a heterocycle in a main chain; and a conductive material.

## Description

### TECHNICAL FIELD

The present invention relates to anisotropic conductive adhesives and connection structures.

### BACKGROUND ART

With the increase in performance and speed, and reduction in size of electronic devices, semiconductor circuits have been miniaturized to a nano-order level. In a semiconductor packaging process, for example, a substrate that performs input and output is electrically connected to and seals a die in which a transistor or wiring capable of performing input and output is formed on a semiconductor, such as silicon. In the case where the connection is achieved by a conventional soldering technique, a wiring pitch on the die side and a wiring pitch on the substrate side are pitches of several tens of micrometers because of the limit due to properties of solder bumps.

In order to overcome the limitation of the wiring pitch on the die side, fan-out wafer level packaging (FOWLP) has been developed, and it is known, as a representative example, that rewiring (redistribution layer, RDL) is performed on an electrode surface of a die by a wafer process, thereby performing, on the surface of the die, formation of an electrode at a wiring pitch connectable to a substrate. Thus, it is possible to miniaturize the wiring inside the die, leading to reduction in size of the die and high performance of the die.

However, not only in the case of the electrode drawn out by FOWLP, but also in the case of through-silicon via (TSV), when the connection between a die and a substrate is achieved by soldering, a pitch of several tens of micrometers, which is a limit due to properties of solder bumps, is an industrial limit.

On the other hand, many alternative techniques to soldering have been studied, and as one of the alternative techniques to soldering, a film-shaped connection material (e.g., an anisotropic conductive film (ACF)) in which a thermoset resin including a conductive material dispersed therein is applied onto a release film is exemplified.

This anisotropic conductive film has been used as a connection material applicable in a low-temperature process, and is used for applications, such as electrical connection for display peripheral devices. For example, as a multilayer substrate having excellent conduction characteristics that can be provided at low costs by stacking semiconductor substrates using an anisotropic conductive film in a simple production process, the following multilayer substrate is reported. That is a multilayer substrate in which semiconductor substrates having through electrodes are stacked. The multilayer substrate has a connection structure in which conductive particles are selectively present at positions where the through electrodes face each other in a plan view of the multilayer substrate, the through electrodes that face each other are connected via the conductive particles, and the semiconductor substrates having the through electrodes are bonded together with an insulating adhesive (see, for example, Patent Document 1).

### CITATION LIST

### PATENT DOCUMENTS

Patent Document 1: Japanese Unexamined Patent Application Publication No. 2020-202409

### SUMMARY OF THE INVENTION

### TECHNICAL PROBLEM

However, as compared with the connection material used for display peripheral devices, a connection material for semiconductor devices is required to have high electrical connection reliability, such as temperature cycles due to hightemperature driving and reflow resistance. The anisotropic conductive film of the related art has a problem that the anisotropic conductive film has not successfully been used as a connection material for a semiconductor, such as FOWLP, in practice.

In addition, the solder connection of the related art has a limitation in narrowing the pitch as described above, and there are problems such that, as miniaturization advances, it becomes difficult to apply underfill for inhibiting short circuits, and since the solder melting temperature is high, i.e., 200°C or higher, the substrate is warped when returned to room temperature, which causes a failure in a subsequent process.

The present invention is intended to solve the various above problems in the art, and to achieve the following object. Specifically, the object of the present invention is to provide an anisotropic conductive adhesive having high electrical connection reliability even after temperature cycles, and having excellent adhesion.

### SOLUTION TO THE PROBLEM

Means for solving the above problems are as follows.
<1> An anisotropic conductive adhesive, including: a resin component that includes a resin including a heterocycle in a main chain; and a conductive material.
<2> The anisotropic conductive adhesive according to claim 1, wherein the resin including the heterocycle in the main chain is represented by a general formula (1) or a general formula (2) below: 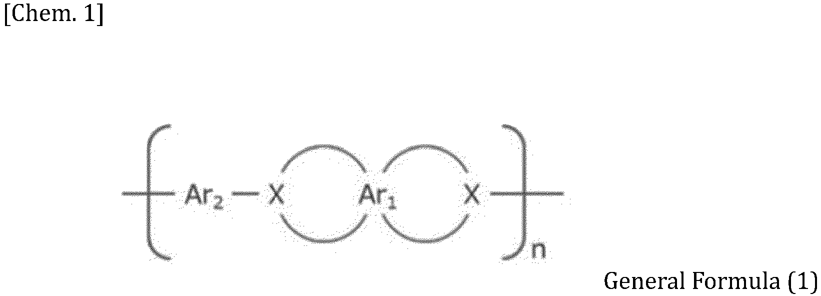
   in the general formula (1), X is a group selected from the group consisting of groups below, Ar₁ and Ar₂ are each an aryl group including one or more benzene rings, and n is an integer, 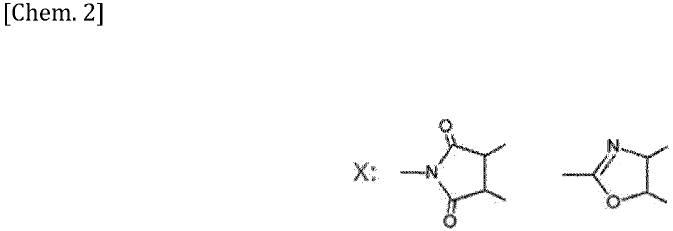 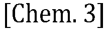 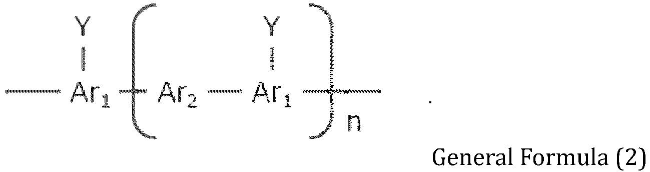
   in the general formula (2), Y is a group below, Ar₁ and Ar₂ are each an aryl group including one or more benzene rings, and n is an integer. 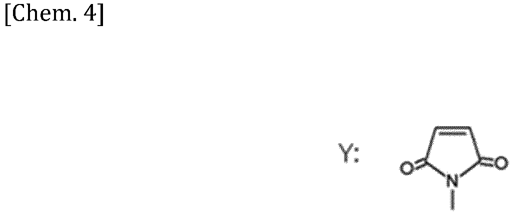
<3> The anisotropic conductive adhesive according to <1>, wherein the resin including the heterocycle in the main chain is represented by a general formula (1) or a general formula (2) blow: 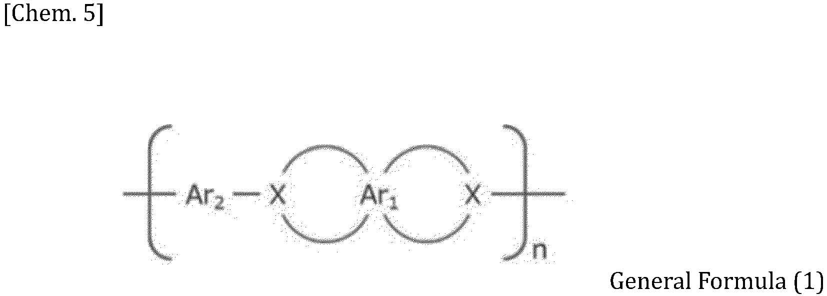
   in the general formula (1), each of X, Ar₁, and Ar₂ is a group selected from the respective group consisting of groups below, and n is an integer, 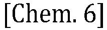 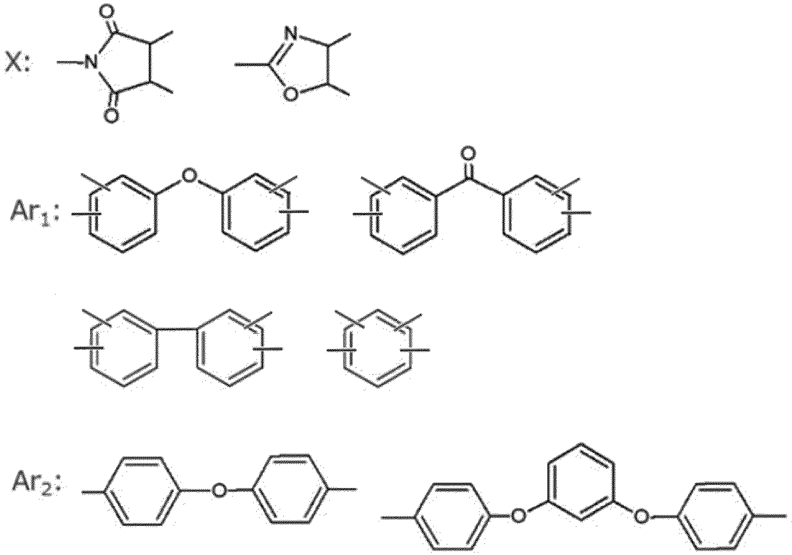 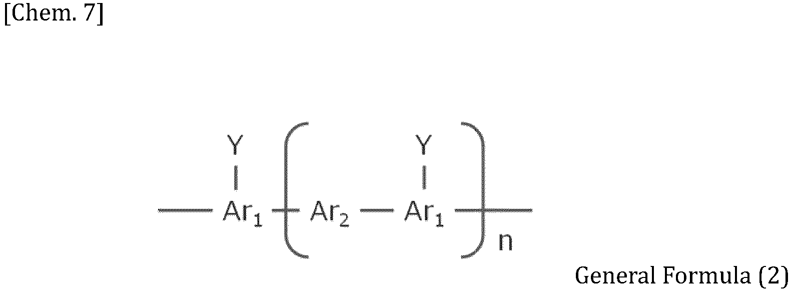
   in the general formula (2), each of Y, Ar₁, and Ar₂ is a group selected from the respective group consisting of one or more groups below, and n is an integer. 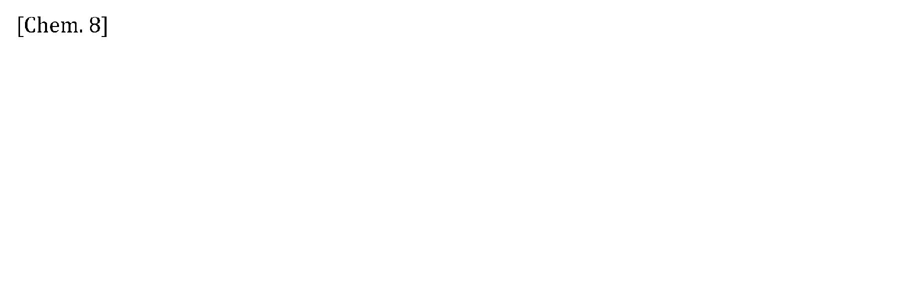 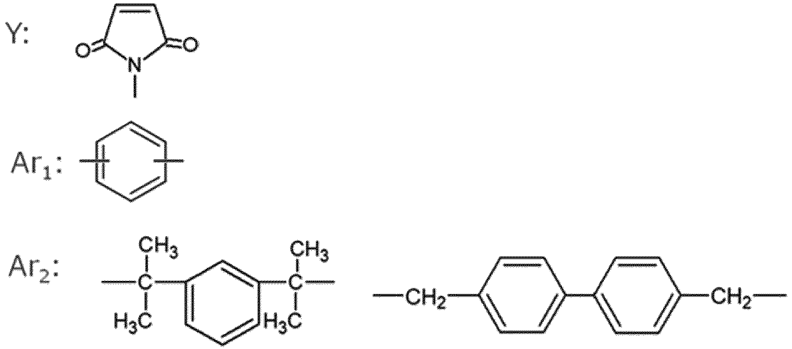
<4> The anisotropic conductive adhesive according to any one of <1> to <3>, wherein an amount of the resin including the heterocycle in the main chain is 20 percent by mass or greater and 80 percent by mass or less relative to a total amount of the resin component.
<5> The anisotropic conductive adhesive according to any one of <1> to <4>, wherein resistivity of the conductive material is 120 × 10⁻⁸ [Ω·m] or less.
<6> The anisotropic conductive adhesive according to any one of <1> to <5>, wherein the conductive material includes at least one selected from the group consisting of Au, Ag, Sn, Pb, Cu, Al, Ni, and Fe.
<7> The anisotropic conductive adhesive according to any one of <1> to <6>, wherein the conductive material includes at least one selected from the group consisting of metal particles, alloy particles, and core-shell particles.
<8> The anisotropic conductive adhesive according to any one of <1> to <7>, further including a curing agent.
<9> The anisotropic conductive adhesive according to any one of <1> to <8>, further including one or more other resins.
<10> The anisotropic conductive adhesive according to any one of <1> to <9>, wherein the anisotropic conductive adhesive is an anisotropic conductive adhesive film.
<11> The anisotropic conductive adhesive according to any one of <1> to <10>, wherein the anisotropic conductive adhesive is an anisotropic conductive adhesive film, in which the conductive material is aligned into a single layer within the resin component that is in a form of a film.
<12> A connection structure, including: a first circuit member; a second circuit member; and the anisotropic conductive adhesive according to any one of <1> to <11> that connects between the first circuit member and the second circuit member with an anisotropic conductive connection.

### EFFECTS OF THE INVENTION

According to the present invention, the various above problems existing in the related art can be solved, the object can be achieved, and an anisotropic conductive adhesive, which has electrical connection reliability even after temperature cycles, and has excellent adhesion, can be provided.

### BRIEF DESCRIPTION OF THE DRAWINGS

[Fig. 1] Fig. 1 is a schematic cross-sectional view of one example of the anisotropic conductive film of the present embodiment.
[Fig. 2] Fig. 2 is a schematic cross-sectional view of another example of the anisotropic conductive film of the present embodiment.
[Fig. 3] Fig. 3 is a cross-sectional view taken along B-B' of Fig. 2.
[Fig. 4] Fig. 4 is a schematic cross-sectional view of yet another example of the anisotropic conductive film of the present embodiment.

### DESCRIPTION OF EMBODIMENTS

### (Anisotropic Conductive Adhesive)

The anisotropic conductive adhesive of the present invention includes a resin component that includes a resin including a heterocycle in a main chain, and a conductive material. The anisotropic conductive adhesive further includes other components, such as a curing agent, as necessary.

The anisotropic conductive adhesive can be suitably used as an anisotropic conductive adhesive in a form of a paste or an anisotropic conductive film in a form of a film, which connects a terminal of a first circuit member and a terminal of a second circuit member, thereby forming an anisotropic conductive connection.

### <Conductive Material>

The conductive material is not particularly limited, as long as the conductive material has conductivity, and may be appropriately selected depending on the intended purpose. Examples of the conductive material include metal particles, alloy particles, core-shell particles, and the like. The above conductive materials may be used alone or in combination of two or more.

The resistivity of the conductive material is preferably 120 × 10⁻⁸ [Ω·m] or less.

As the conductive material, for example, at least one selected from the group consisting of Au, Ag, Sn, Pb, Cu, Al, Ni, and Fe is preferably included.

The metal particles are particles formed of a single metal. The metal is not particularly limited, and may be appropriately selected depending on the intended purpose. Examples of the metal include Au, Ag, Sn, Pb, Cu, Al, Ni, Fe, and the like.

The alloy particles are particles formed of an alloy of a plurality of metals. The alloy preferably includes two or more metals selected from the group consisting of Au, Ag, Sn, Pb, Cu, Al, Ni, and Fe.

Among the above, the conductive material preferably includes at least one selected from the group consisting of Ni, Ag, and Cu. The surfaces of the above conductive materials may be coated with Au or Pd (palladium) for the purpose of inhibiting surface oxidation. Further, an insulating film may be formed on the surface of the conductive material using an organic material.

The core-shell particles are not particularly limited, as long as the core-shell particles are particles in which metal particles, alloy particles, or resin particles serving as cores are each coated with a shell of a metal or an alloy that is different from the material of the cores, and may be appropriately selected depending on the intended purpose. Examples of the core-shell particles include particles, in which surfaces of metal particles, alloy particles, or resin particles are each coated with at least one metal selected from the group consisting of Au, Ag, Sn, Pb, Cu, Al, Ni, and Fe or an alloy, and the like.

The shell may cover the entire surface of the core, or may cover a part of the surface of the core. Further, each of the surfaces of the core particles may be provided with metal protrusions, or may be coated with an insulating film using an organic material. In the case of a connection considering low resistance, particles in which surfaces of resin particles are each coated with Au or Ag are preferable.

A method for coating the resin particles with a metal or an alloy is not particularly limited, and may be appropriately selected depending on the intended purpose. Examples of the coating method include electroless plating, sputtering, and the like.

A material of the resin particles is not particularly limited, and may be appropriately selected depending on the intended purpose. Examples of the material of the resin particles include styrene-divinylbenzene copolymers, benzoguanamine resins, crosslinked polystyrene resins, acrylic resins, styrene-silica composite resins, and the like.

The conductive material may have conductivity when an anisotropic conductive connection is formed. For example, even particles in which surfaces of metal particles are each coated with an insulating film are classified as the conductive material, if the particles are deformed, thereby exposing the metal particles, when an anisotropic conductive connection is formed.

An average particle diameter of the conductive material is not particularly limited, and may be appropriately selected depending on the intended purpose. The average particle diameter of the conductive material is preferably 1 µm to 50 µm, more preferably 2 µm to 25 µm, and particularly preferably 2 µm to 10 µm.

The average particle diameter is an average value of particle diameters measured on any ten particles of the conductive material.

The particle diameters can be measured, for example, by observing the conductive material under a scanning electron microscope.

An amount of the conductive material is not particularly limited, and may be appropriately selected depending on the intended purpose. The amount of the conductive material is 2 parts by mass to 200 parts by mass, and more preferably 5 parts by mass to 100 parts by mass, relative to 100 parts by mass of the resin component.

### <Resin Component>

The resin component includes a resin including a heterocycle in a main chain, and preferably further includes one or more other resins, such as a film forming resin, a thermoset resin, and the like, as necessary.

The resin component includes the resin including the heterocycle in the main chain, which has excellent heat resistance. Thus, the anisotropic conductive adhesive that can maintain a state of low deformation or minimal deterioration even after temperature cycles owing to properties of the resin having high resistance to deformation or deterioration that may be caused by heat, having high electrical connection reliability satisfying the specification of semiconductor connection, and having excellent adhesion can be provided.

### <<Resin Including Heterocycle in Main Chain>>

The resin including the heterocycle in the main chain is a resin that includes a heterocycle in a main chain, where the heterocycle is a ring including a heteroatom that is any atom other than carbon and hydrogen. Examples of the heteroatom include nitrogen N and oxygen O. N and O are preferably included.

The resin including the heterocycle in the main chain is not particularly limited, and may be appropriately selected depending on the intended purpose. Examples of the resin including the heterocycle in the main chain include polyimide, polybenzoxazole, polymaleimide, and the like.

The above resins may be used alone or in combination of two or more.

Suitable examples of the polyimide or the polybenzoxazole include resins represented by the following general formula (1).

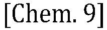

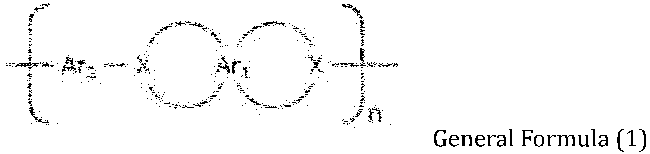

In the general formula (1), X is a group selected from the group consisting of the following groups, Ar₁ and Ar₂ are each an aryl group including one or more benzene rings, and n is an integer.

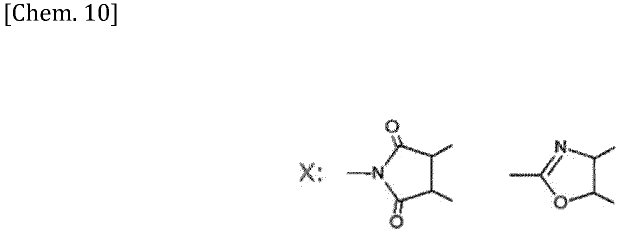

The "aryl group including one or more benzene rings" is not particularly limited as long as the group includes one or more benzene rings, and may be appropriately selected according to the intended purpose. The "aryl group including one or more benzene rings" may include a substituent, and preferably includes one, two, or three benzene rings.

In the case where two or more benzene rings are included, the benzene rings are preferably linked together via a bond, such as a covalent bond, an ether group (-0-), a carbonyl group (-C(=O)-), or the like.

Examples of the substituent include: alkyl groups (monovalent groups), such as methyl groups; alkylene groups (divalent groups), such as methylene groups and isopropylidene groups (=C(CH₃)₂); and the like.

Among the above, Ar₁ and Ar₂ are each preferably a group selected from the respective group consisting of the following.

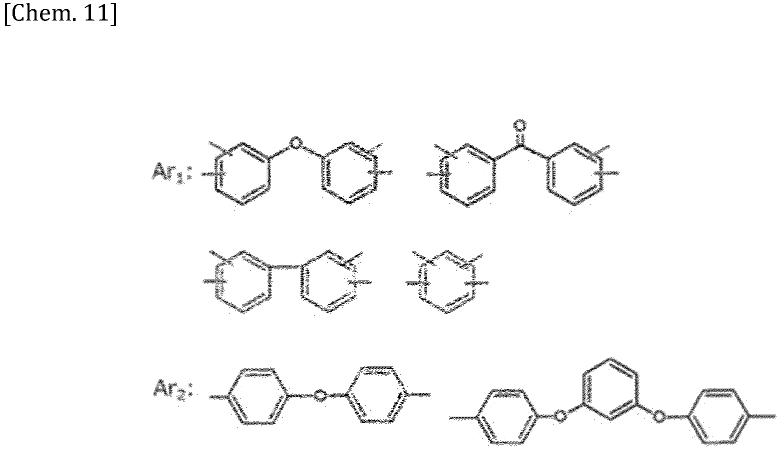

Among the resins represented by the general formula (1), a resin represented by the following general formula (1-1), a resin represented by the following general formula (1-2), and a mixture of the foregoing are preferable.

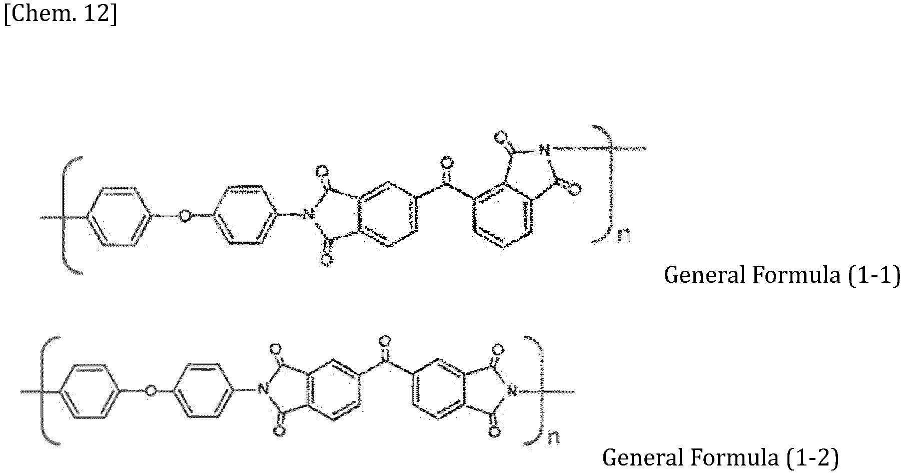

Suitable examples of the polymaleimide include resins represented by the following general formula (2).

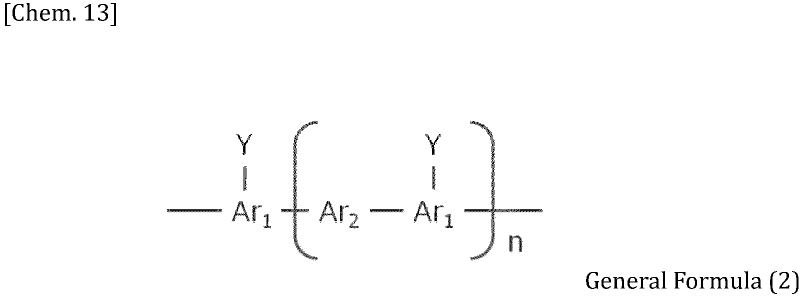

In the general formula (2), Y is a group presented below, Ar₁ and Ar₂ are each an aryl group including one or more benzene rings, and n is an integer.

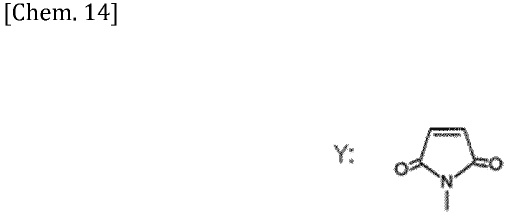

The "aryl group including one or more benzene rings" is not particularly limited as long as the group includes one or more benzene rings, and may be appropriately selected according to the intended purpose. The "aryl group including one or more benzene rings" may include a substituent, and preferably include one, two, or three benzene rings.

In the case where two or more benzene rings are included, the benzene rings are preferably linked together via a bond, such as a covalent bond, an ether group (-0-), a carbonyl group (-C(=O)-), or the like.

Examples of the substituent include: alkyl groups (monovalent groups), such as methyl groups; alkylene groups (divalent groups), such as methylene groups and isopropylidene groups (=C(CH₃)₂); and the like.

Among the above, Ar₁ and Ar₂ are each preferably a group selected from the respective group consisting of the following.

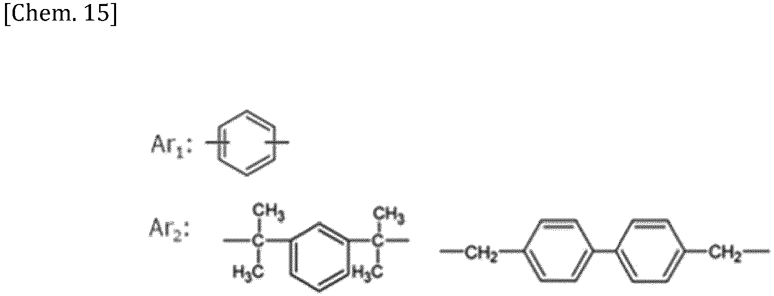

Among the resins represented by the general formula (2), a resin represented by the following general formula (2-1) is preferable.

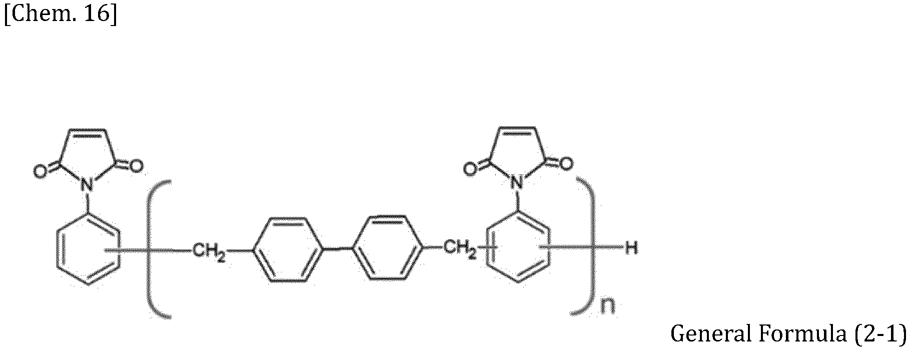

As the resin including the heterocycle in the main chain, an appropriately synthesized resin may be used, or a commercially available product may be used. Examples of the resin including the heterocycle in the main chain include: polyimide, such as a soluble polyimide resin KPI-MX300F (manufactured by Kawamura Sangyo Co., Ltd.) and polyimide disclosed in Japanese Unexamined Patent Application Publication No. 2005-272655 (e.g., polyimide of Example 1; polybenzoxazole, such as SUMIRESIN EXCEL CRC-8300 (manufactured by Sumitomo Bakelite Co., Ltd.); polymaleimide, such as polymaleimide obtained by polymerizing bismaleimide MIR-3000-70MT (manufactured by NIPPON KAYAKU Co., Ltd.); and the like.

An amount of the resin including the heterocycle in the main chain is not particularly limited, and may be appropriately selected depending on the intended purpose. The amount of the resin including the heterocycle in the main chain is preferably 10 percent by mass or greater and 90 percent by mass or less, and more preferably 20 percent by mass or greater and 80 percent by mass or less, relative to a total amount of the resin component.

### <<Other resins>>

The resin component preferably includes, in addition to the resin including the heterocycle in the main chain, one or more other resins, such as a film forming resin, a thermoset resin, and the like.

The one or more other resins and the curing agent may be bonded to the resin including the heterocycle in the main chain, or may be mixed with the resin including the heterocycle in the main chain, as additives.

In the case where the resin including the heterocycle in the main chain includes a reactive functional group, such as a cyclic ether group, a double bond group, and the like, it is advantageous because a resin component and a cured product of the resin component that exhibit higher electrical connection reliability can be obtained due to a bonding reaction or crosslinking reaction with the one or more other resins.

### -Film Forming Resin-

The film forming resin is not particularly limited, and may be appropriately selected depending on the intended purpose. Examples of the film forming resin include phenoxy resins, acrylic resins, unsaturated polyester resins, saturated polyester resins, urethane resins, butadiene resins, polyamide resins, polyolefin resins, and the like. The film forming resin may be used alone, or in combination of two or more. Among the above film forming resins, a phenoxy resin is preferable from the viewpoint of heat stability, film formability, processability, and connection reliability, and an acrylic resin is preferable from the viewpoint of flexibility and adhesion.

Examples of the phenoxy resin include a resin synthesized from bisphenol A and epichlorohydrin, and the like.

As the phenoxy resin, an appropriately synthesized phenoxy resin may be used, or a commercially available product may be used.

An amount of the film forming resin is not particularly limited, and may be appropriately selected depending on the intended purpose. The amount of the film forming resin is preferably 0 percent by mass or greater and 80 percent by mass or less, more preferably 20 percent by mass or greater and 70 percent by mass or less, and yet more preferably 30 percent by mass or greater and 70 percent by mass or less, relative to the resin component.

### -Thermoset Resin-

The thermoset resin (thermoset component) is not particularly limited, and may be appropriately selected depending on the intended purpose. Examples of the thermoset resin include epoxy resins, radical polymerizable compounds, and the like.

### --Epoxy Resin--

The epoxy resin is not particularly limited, and may be appropriately selected depending on the intended purpose. Examples of the epoxy resin include thermoset epoxy resins, such as bisphenol A epoxy resins, bisphenol F epoxy resins, novolac epoxy resins, modified epoxy resins of the foregoing, and the like. The above epoxy resins may be used alone or in combination of two or more.

### --Radical Polymerizable Compound--

The radical polymerizable compound is not particularly limited, and may be appropriately selected depending on the intended purpose. Example of the radical polymerizable compound include methyl acrylate, ethyl acrylate, isopropyl acrylate, isobutyl acrylate, phosphoric acid group-containing acrylate, ethylene glycol diacrylate, diethylne glycol diacrylate, trimethylolpropane triacrylate, dimethyloltricyclodecane diacrylate, tetramethylene glycol tetraacrylate, 2-hydroxy-1,3-dacryloxypropne, 2,2-bis[4-(acryloxymethoxy)phenyl]propane, 2,2-bis[4-(acryloxyethoxy)phenyl]propane, dicyclopentenyl acrylate, tricyclodecanyl acrylate, tris(acryloxyethyl)isocyanurate, urethane acrylate, epoxy acrylate, and the like. In addition, compounds using methacrylates instead of the above acrylates may also be used. The above thermoset resins may be used alone or in combination of two or more.

An amount of the thermoset resin is not particularly limited, and may be appropriately selected depending on the intended purpose. The amount of the thermoset resin is preferably 0 percent by mass or greater and 80 percent by mass or less, more preferably 20 percent by mass or greater and 70 percent by mass or less, and yet more preferably 30 percent by mass or greater and 70 percent by mass or less, relative to the resin component.

### <Other Components>

The other components are not particularly limited, and may be appropriately selected depending on the intended purpose. Examples of the other components include a curing agent, a silane coupling agent, and the like.

### <<Curing Agent>>

The curing agent is not particularly limited, as long as the curing agent has a function of curing the thermoset resin by heat, and may be appropriately selected depending on the intended purpose. Examples of the curing agent include cationic curing agents, radical curing agents, and the like.

### -Cationic Curing Agent-

The cationic curing agent is not particularly limited, and may be appropriately selected depending on the intended purpose. Examples of the cationic curing agent include sulfonium salts, onium salts, and the like. Among the above, aromatic sulfonium salts are preferable.

The cationic curing agent is preferably used in combination with an epoxy resin serving as the thermoset resin.

### -Radical Curing Agent-

The radical curing agent is not particularly limited, and may be appropriately selected depending on the intended purpose. Examples of the radical curing agent include organic peroxides and the like.

The radical curing agent is preferably used in combination with a radical polymerizable compound serving as the thermoset resin.

An amount of the curing agent is not particularly limited, and may be appropriately selected depending on the intended purpose. The amount of the curing agent is preferably 1 part by mass or greater and 10 parts by mass or less, and more preferably 3 parts by mass or greater and 7 parts by mass or less, relative to 100 parts by mass of the resin component.

### <<Silane Coupling Agent>>

The silane coupling agent is not particularly limited, and may be appropriately selected depending on the intended purpose. Examples of the silane coupling agent include epoxy-based silane coupling agents, acrylic silane coupling agents, thiol-based silane coupling agents, amine-based silane coupling agents, and the like.

An amount of the silane coupling agent is not particularly limited, and may be appropriately selected depending on the intended purpose.

### [Anisotropic Conductive Adhesive Film]

The anisotropic conductive adhesive is suitably used as an embodiment of an anisotropic conductive adhesive film.

The anisotropic conductive adhesive film may be a conductive material dispersed-type film in which the conductive material is dispersed in the resin component in the form of a film, or a conductive material aligned-type film in which the conductive material is aligned into a single layer within the resin component in the form of a film. Both types of the films can be suitably used for the anisotropic conductive connection between a terminal of a first circuit member and a terminal of a second circuit member.

The anisotropic conductive adhesive film preferably further includes a releasable substrate.

An average thickness of the anisotropic conductive adhesive film is not particularly limited, and may be appropriately selected depending on the intended purpose. The average thickness of the anisotropic conductive adhesive is preferably 2 µm to 50 µm, more preferably 3 µm to 40 µm, and particularly preferably 3 µm to 25 µm.

The average thickness is an arithmetic mean of values obtained by measuring at any ten points of the anisotropic conductive adhesive film.

A method for aligning the conductive material in the conductive material aligned-type of the anisotropic conductive adhesive film is not particularly limited, and may be appropriately selected depending on the intended purpose. Examples of the method include: a method using a biaxial stretching processing on a nonstretched polypropylene film of Example 1 of Japanese Patent No. 4789738; a method using a mold described in Japanese Unexamined Patent Application Publication No. 2010-33793; and the like.

As a manner of the alignment, the conductive material is preferably aligned into a single layer in a manner such that the particles of the conductive material are two-dimensionally set apart from one another at a distance of approximately 1 µm to 100 µm in consideration of the size of connection targets, conduction reliability, insulation, particle capturing efficiency, and the like.

### <Releasable Substrate>

The releasable substrate can be used without any particular limitation, as long as the releasable substrate is a film that can be released from the anisotropic conductive film at the time of temporary bonding.

Examples of the releasable substrate include silicone-based films, fluorinebased films, polyethylene terephthalate (PET) subjected to a release treatment with a release agent, polyethylene naphthalate (PEN) subjected to a release treatment with a release agent, glassine paper subjected to a release treatment with a release agent, and the like.

Examples of the release agent include silicone-based release agents, fluorinebased release agents, and the like.

Among the above, a substrate subjected to a release treatment with a silicone-based release agent is preferable.

The releasable substrate is disposed to be in contact with the anisotropic conductive film.

A surface of the releasable substrate to be in contact with the anisotropic conductive film is preferably subjected to a release treatment, and a surface of the release substrate opposite to the surface in contact with the anisotropic conductive film may not be subjected to a release treatment.

An average thickness of the releasable substrate is not particularly limited, and may be appropriately selected depending on the intended purpose. The average thickness of the releasable substrate is preferably 12 µm to 75 µm.

Examples of the anisotropic conductive film of the present embodiment will be described with reference to the drawings.

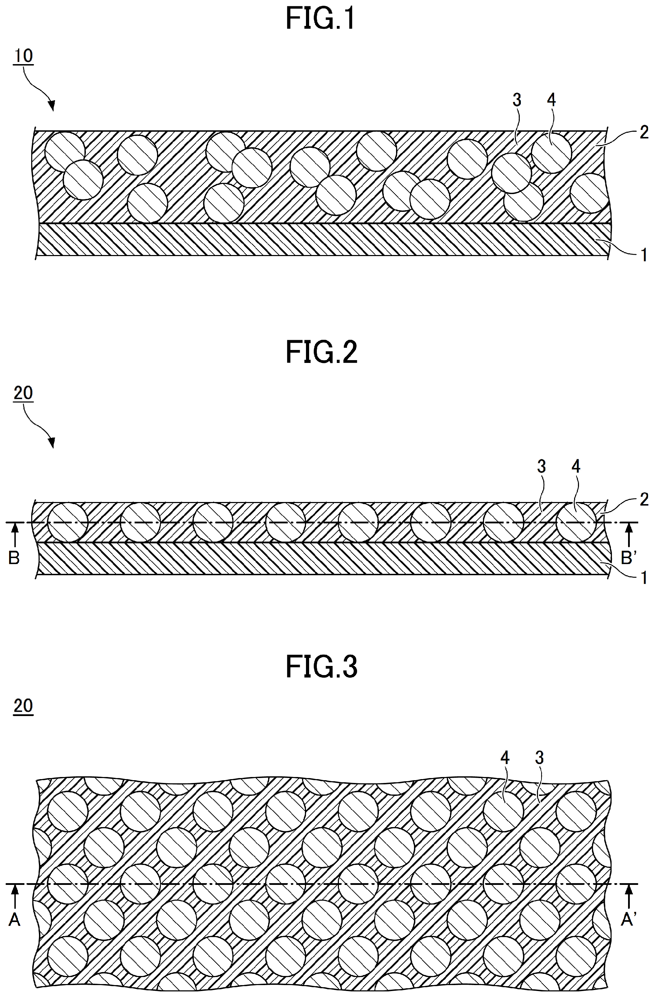

Fig. 1 is a schematic cross-sectional view of one example of the anisotropic conductive film of the present embodiment. The anisotropic conductive film 10 of Fig. 1 includes an anisotropic conductive adhesive 2 in the form of a film on a releasable substrate 1. The anisotropic conductive adhesive 2 is a conductive material dispersed-type film, which includes a resin component 3 and a conductive material 4 dispersed in the resin component 3.

Fig. 2 is a schematic cross-sectional view of another example of the anisotropic conductive film of the present embodiment, and is a cross-sectional view taken along A-A' of Fig. 3. Fig. 3 is a cross-sectional view taken along B-B' of Fig. 2. The anisotropic conductive film 20 of Figs. 2 and 3 includes an anisotropic conductive adhesive 2 in the form of a film on a releasable substrate 1. The anisotropic conductive adhesive 2 is a conductive material aligned-type film that includes a resin component 3 and a conductive material 4 that is aligned into a single layer within the resin component 3. The size of the particles of the conductive material 4 is substantially the same as the average thickness of the anisotropic conductive adhesive 2.

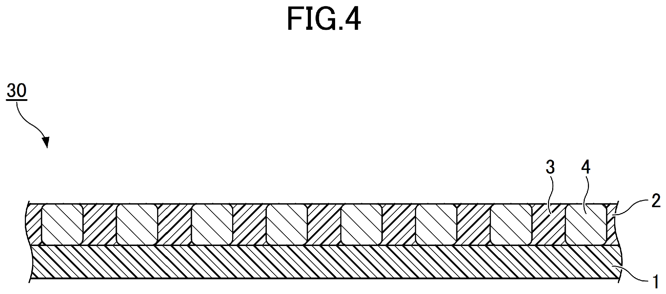

Fig. 4 is a schematic cross-sectional view of another example of the anisotropic conductive film of the present embodiment. The anisotropic conductive film 30 of Fig. 4 is a modification example of the anisotropic conductive film 20 of Examples 2 and 3, and is a conductive material aligned-type film in which, instead of the spherical conductive material 4, the conductive material 4 in the shape of substantially quadrangular prisms is aligned into a single layer within the resin component 3. The alignment pattern of the conductive material 4 is, as one example, a 60° staggered pattern.

The shape of the conductive material 4 is not particularly limited, and may be appropriately selected depending on the intended purpose. Examples of the shape of the conductive material 4 include: spherical shapes; spheroidal shapes; columnar shapes, such as cylindrical shapes, elliptic cylindrical shapes, substantially quadrangular columnar shapes, substantially equilateral triangular shapes, and substantially hexagonal shapes; and the like.

The alignment pattern of the conductive material 4 is not particularly limited, and may be appropriately selected depending on the intended purpose. The particles of the conductive material are preferably regularly aligned into a single layer without being in contact with one another. Examples of the alignment pattern include patterns, such as 60° staggered patterns, 45° staggered patterns, square parallel patterns, regular hexagon 60° staggered patterns, regular triangle alignments, square alternate patterns, and the like.

The "60° staggered pattern" is an alignment pattern in which each of the centers of the particles of the conductive material is aligned as a vertex of regular triangles that are aligned to share the sides as viewed in a plan view. The "45° staggered pattern" is an alignment pattern in which each of the centers of the particles of the conductive material is aligned as a vertex of isosceles right triangles that are aligned to share the sides as viewed in a plan view.

The size of the conductive material 4 is not particularly limited, and may be appropriately selected depending on the intended purpose. The size of the conductive material 4 is preferably 1/5 or greater and 1 or less of the average thickness of the anisotropic conductive adhesive 2, because each particle of the conductive material 4 can be exposed from the surfaces of the anisotropic conductive adhesive 2 to efficiently form an anisotropic conductive connection when the anisotropic conductive film 20 or 30 is disposed between a terminal of a first circuit member and a terminal of a second circuit member.

In Figs. 2 and 4, the size of the conductive material 4 is substantially the same as the average thickness of the anisotropic conductive adhesive 2. In the case where the size of the conductive material 4 is smaller than the average thickness of the anisotropic conductive adhesive 2, the conductive material 4 may be disposed along a surface of the anisotropic conductive adhesive 2 opposite to the surface at the side of the releasable substrate 1, or may be disposed inside the anisotropic conductive adhesive 2, and either arrangement can be appropriately selected according to the intended embodiment.

### (Connection Structure)

The connection structure of the present invention includes a first circuit member, a second circuit member, and the above-described anisotropic conductive adhesive or anisotropic conductive adhesive film of the present embodiment that connects between the first circuit member and the second circuit member with an anisotropic conductive connection. The connection structure may further include other members, as necessary.

### <First Circuit Member and Second Circuit Member>

Each of the first circuit member and the second circuit member is not particularly limited, as long as the first circuit member and the second circuit member are each a circuit member that has a terminal and can be a target for the anisotropic conductive connection using the anisotropic conductive adhesive or anisotropic conductive film. The first circuit member and the second circuit member may be appropriately selected depending on the intended purpose. Examples of the first circuit member and the second circuit member include glass substrates each having a terminal, plastic substrates each having a terminal, integrated circuits (IC), (tape automated bonding (TAB) tapes, flex-on-glass (FOG), chip-on-glass (COG), chip-on-flex (COF), flex-on-board (FOB), flex-on-flex (FOF), liquid crystal panels, and the like.

Examples of the glass substrate having the terminal include indium tin oxide (ITO) glass substrates, indium zinc oxide (IZO) glass substrates, other patterned glass substrates, and the like. Among the above, an ITO glass substrate and an IZO glass substrate are preferable.

A material and structure of the plastic substrate having the terminal are not particularly limited, and may be appropriately selected depending on the intended purpose. Examples of the plastic substrate having the terminal include rigid substrates each having a terminal, flexible substrates each having a terminal, and the like.

Examples of the IC include IC chips for controlling liquid crystal screens in flat panel displays (FPD) and the like.

A shape and size of each of the first circuit member and the second circuit member are not particularly limited, and may be appropriately selected depending on the intended purpose.

The first circuit member and the second circuit member may be the same circuit members, or different circuit members.

### [Production Method for Connection Structure and Connection Method]

A production method for the connection structure of the present embodiment, and a connection method for connecting using the anisotropic conductive adhesive or anisotropic conductive film of the present embodiment are not particularly limited, and may be appropriately selected depending on the intended purpose. For example, the production method and the connection method are suitably performed by a method that includes at least a first arrangement step, a second arrangement step, and a heat press step, and further includes other steps, such as a temporary bonding step, and the like, as necessary.

The connection method is a method for connecting between a terminal of a first circuit member and a terminal of a second circuit member with an anisotropic conductive connection.

The first circuit member and the second circuit member are not particularly limited, and may be appropriately selected depending on the intended purpose. Examples of the first circuit member and the second circuit member include the first circuit member and the second circuit member listed in the description of the anisotropic conductive film of the present embodiment.

### <First Arrangement Step>

The first arrangement step is not particularly limited, as long as the first arrangement step is a step in which the anisotropic conductive film of the present embodiment is arranged on a terminal of the first circuit member to be in contact with the terminal of the first circuit member, and may be appropriately selected depending on the intended purpose.

### <Second Arrangement Step>

The second arrangement step is not particularly limited, as long as the second circuit member is a step in which the second circuit member is arranged on the anisotropic conductive film so that a terminal of the second circuit member is in contact with the anisotropic conductive film, and may be appropriately selected depending on the intended purpose.

### <Heat Press Step>

The heat press step is not particularly limited, as long as the heat press step is a step in which the second circuit member is heated and pressed by a heat press member, and may be appropriately selected depending on the intended purpose.

Examples of the heat press member include a press member having a heating mechanism. Examples of the press member having the heating mechanism include a heat tool and the like.

The temperature of the heating is not particularly limited, and may be appropriately selected depending on the intended purpose. The temperature is preferably 150°C to 200°C.

The pressure of the pressing is not particularly limited, and may be appropriately selected depending on the intended purpose. The pressure is preferably 0.1 MPa to 50 MPa.

The heating and pressing time is not particularly limited, and may be appropriately selected depending on the intended purpose. For example, the heating and pressing time is 0.5 seconds to 120 seconds.

### <Temporary Bonding Step>

The temporary bonding step is not particularly limited, as long as the temporary bonding step is a step in which, after the first arrangement step, the anisotropic conductive film is heated and pressed at a temperature lower than the heating temperature in the heat press step, thereby bonding the anisotropic conductive film to the first circuit member, and may be appropriately selected depending on the intended purpose.

The heating and pressing can be performed, for example, by a heat press member. Examples of the heat press member include a press member having a heating mechanism. Examples of the press member having the heating mechanism include a heat tool and the like.

In the case where the releasable substrate is disposed on the conductive material side of the anisotropic conductive film, the temporary bonding step is performed in the state in which the anisotropic conductive film is provided with the releasable substrate, and the releasable substrate is preferably released from the anisotropic conductive film after the temporary bonding step.

The temperature of the heating in the temporary bonding step is not particularly limited, as long as the temperature is lower than the heating temperature of the heat press step, and may be appropriately selected depending on the intended purpose. The temperature is preferably 50°C to 110°C. The heating temperature is preferably a temperature at which the anisotropic conductive film is not cured.

The pressure of the pressing in the temporary bonding step is not particularly limited, and may be appropriately selected depending on the intended purpose. The pressure is preferably 0.1 MPa to 10 MPa.

The heating and pressing time in the temporary bonding step is not particularly limited, and may be appropriately selected depending on the intended purpose. For example, the heating and pressing time is 0.5 seconds to 10 seconds.

### Examples

Hereinafter, examples of the present invention will be described, but the present invention is not limited to Examples in any way.

### (Example 1)

### <Production of Anisotropic Conductive Adhesive>

Polyimide (soluble polyimide of Example 1 of Japanese Unexamined Patent Application Publication No. 2005-272655, a product synthesized by the applicant), which was a mixture of a resin represented by the following general formula (1-1) and a resin represented by the following general formula (1-2), was dissolved in N-methylpyrrolidone (NMP) at a concentration of 15 percent by mass, thereby preparing a polyimide solution.

To 100 parts by mass of a resin component, in which the polyimide solution and an epoxy resin (EXA-850CRP, manufactured by DIC Corporation) were mixed at a solid ratio of 50:50, 5 parts by mass of Curezol (2E4MZ, manufactured by SHIKOKU KASEI HOLDINGS CORPORATION) serving as a curing agent was further added and mixed. For the mixing, a planetary stirring device (THINKY MIXER ARE-312, manufactured by THINKY CORPORATION) was used. To the obtained mixture, Ni particles (diameter: 3 µm, NIEJB-003-S, manufactured by SEKISUI CHEMICAL CO., LTD.) serving as a conductive material were added in a manner such that the amount of Ni particles was 50 parts by mass relative to 100 parts by mass of the resin component. The resultant mixture was further mixed to disperse the conductive material, thereby obtaining an anisotropic conductive adhesive of Example 1.

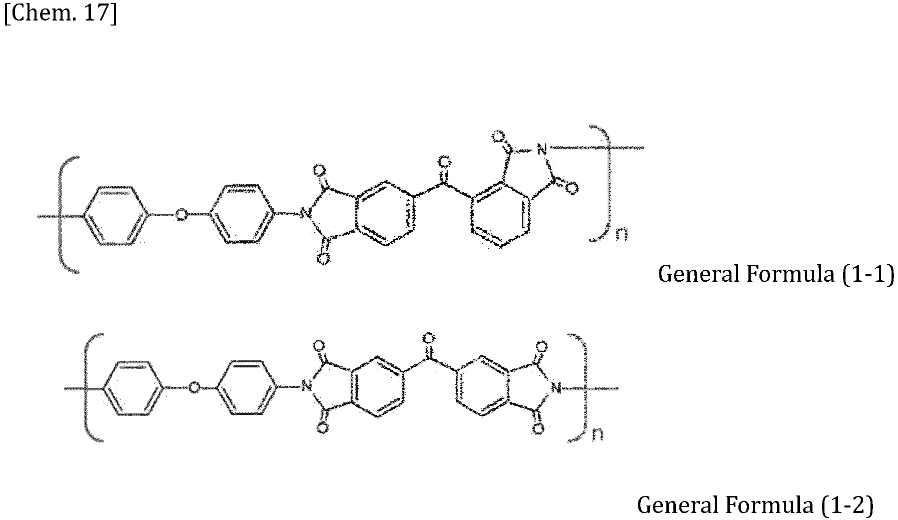

### <Production of Anisotropic Conductive Film>

The obtained anisotropic conductive adhesive was applied onto a polyethylene terephthalate (PET) film (UH-4, film average thickness: 50 µm, manufactured by TEIJIN LIMITED) by a bar coater, followed by heating at 80°C for 10 minutes using a dry oven to remove the solvent, thereby obtaining an anisotropic conductive film of Example 1 having an average thickness of 15 µm.

### (Example 2)

An anisotropic conductive adhesive and anisotropic conductive film of Example 2 were obtained in the same manner as in Example 1, except that the solid ratio (mass ratio) of the polyimide to the epoxy resin was changed from 50:50 to 20:80.

### (Example 3)

An anisotropic conductive adhesive and anisotropic conductive film of Example 2 were obtained in the same manner as in Example 1, except that the solid ratio (mass ratio) of the polyimide to the epoxy resin was changed from 50:50 to 80:20.

### (Example 4)

An anisotropic conductive adhesive and anisotropic conductive film of Example 4 were obtained in the same manner as in Example 1, except that the epoxy resin was changed to an acrylic resin (product name: ACMO, manufactured by KJ Chemicals Corporation).

### (Example 5)

An anisotropic conductive adhesive and anisotropic conductive film of Example 5 were obtained in the same manner as in Example 1, except that the polyimide was changed to polybenzoxazole (SUMIRESIN EXCEL CRC-8300, manufactured by Sumitomo Bakelite Co., Ltd.).

### (Example 6)

An anisotropic conductive adhesive and anisotropic conductive film of Example 5 were obtained in the same manner as in Example 1, except that the polyimide was changed to bismaleimide (MIR-3000-70MT, manufactured by NIPPON KAYAKU Co., Ltd.).

### (Example 7)

An anisotropic conductive film intermediate product having an average thickness of 4 µm was obtained in the same manner as in Example 1, except that the conductive material was not added.

Subsequently, Ni particles (diameter: 3 µm, NIEJB-003-S, manufactured by SEKISUI CHEMICAL CO., LTD.) were aligned on the obtained anisotropic conductive film intermediate product according to the process described in Japanese Unexamined Patent Application Publication No. 2010-33793, thereby obtaining an anisotropic conductive film of Example 7.

### (Comparative Example 1)

An anisotropic conductive adhesive and anisotropic conductive film of Comparative Example 1 were obtained in the same manner as in Example 1, except that the solid ratio (mass ratio) of the polyimide to the epoxy resin was changed from 50:50 to 0:100.

### <Evaluations>

"Initial conduction characteristics", "electrical connection reliability after temperature cycles", and "adhesion" were evaluated for each of the obtained anisotropic conductive films in the following manner. The results are presented in Table 1.

### <Initial Conduction Characteristics>

### <<Production of Pressure Bonded Laminate>>

As each evaluation substrate, a flexible printed circuit board (FPC) having Cu/Ni/Au plated wiring (wiring width: 25 µm, and distance between wirings: 25 µm at pitch of 50 µm) was used. The anisotropic conductive film was placed between two evaluation substrates, and the resultant stack was bonded by thermal compression bonding at 2 MPa and 180°C for 20 seconds using a constant heat head compression bonder (BD-01 desktop thermocompression bonding device, manufactured by OHASHI ENGINEERING Co., Ltd.), thereby producing a pressure-bonded laminate for evaluation.

### <<Evaluation of Initial Conduction Characteristics>>

A current was passed through the obtained pressure-bonded laminate to measure the initial conduction resistance.

Specifically, a resistance value was measured by measuring a voltage value when a current 1 mA was passed through the pressure-bonded laminate using a digital multimeter (product number: digital multimeter 7555, manufactured by Yokogawa Electric Corporation) according to a four terminal method. The resistance value was measured at 30 channels of the pressure-bonded laminate, and the maximum resistance value was determined as the measured value, and evaluated according to the following evaluation criteria.

### [Evaluation Criteria]

∘: The conduction resistance was 1 Ω or less.
Δ: The conduction resistance was greater than 1 Ω and 2 Ω or less.
×: The conduction resistance was greater than 2 Ω.

The evaluation "∘" indicates that the conduction resistance is sufficiently low, the evaluation "△" indicates that the conduction resistance is at a practically usable level, and the evaluation "×" indicates that the conduction resistance is not practically usable.

### <Electrical Connection Reliability after Temperature Cycles>

### <<Thermal Cycle Test>>

The obtained the pressure-bonded laminate was set in a highly accelerated stress test chamber (EHS-212MD, manufactured by ESPEC CORP.), and a thermal cycle test (1 cycle: -55°C for 30 minutes, followed by 125°C for 30 minutes, 500 cycles in total), thereby obtaining the pressure-bonded laminate subjected to the temperature cycles.

### <<Electrical Connection Reliability>>

The conduction resistance was measured and evaluated as in <<Evaluation of Initial Conduction Characteristics>> and according to the evaluation criteria, except that the pressure-bonded laminate subjected to the temperature cycles was used.

### <Adhesion>

The pressure-bonded laminate subjected to the temperature cycles was observed using an ultrasonic imaging device (SAT, FS300IIIHR, manufactured by Hitachi Power Solutions Co., Ltd.) to inspect the adhesion of the anisotropic conductive film with the substrates, and presence or absence of voids in the anisotropic conductive film. A probe of 50 MHz and 7 mm was used on the copper plate side, and a probe of 25 MHz was used on the silicon plate side.

### [Evaluation Criteria]

∘: Lifting from the substrate, peeling, or voids are present in less than 0.1% of the observation field, which is within a practically usable range.
×: Lifting from the substrate, peeling, or voids are present in 0.1% or greater of the observation field, which is outside a practically usable range.

**[Table 1]**

| | | Example | | | | | | Comparative Example |
|---|---|---|---|---|---|---|---|---|
| | | 1 | 2 | 3 | 4 | 5 | 6 | 1 |
| Resin including heterocycle in main chain | Polyimide | 50 | 20 | 80 | 50 | - | - | - |
| | Polybenzoxazole | - | - | - | - | 50 | - | - |
| | Bismaleimide | - | - | - | - | - | 50 | - |
| One or more other resins | Epoxy resin | 50 | 80 | 20 | - | 50 | 50 | 100 |
| | Acrylic resin | - | - | - | 50 | - | - | - |
| Conductive material | Dispersed-type Ni particles | ○ | ○ | ○ | ○ | ○ | - | ○ |
| | Aligned-type Ni particles | - | - | - | - | - | ○ | - |
| Evaluation results | Initial conduction characteristics | ○ | ○ | ○ | ○ | ○ | ○ | ○ |
| | Electrical connection reliability after temperature cycles | ○ | ○ | ○ | ○ | ○ | ○ | ○ |
| | Adhesion | ○ | ○ | ○ | ○ | ○ | ○ | × |

This international application claims prioritybased on Japanese Patent Application No. 2024-008455 filed on Janyary 24, 2024, and Japanese Patent Application No. 2025-003316 filed on Jabyary 9, 2025, the entire contents of which are incorporated herein by reference.

### REFERENCE SIGNS LIST

- 1: releasable substrate
- 2: anisotropic conductive adhesive
- 3: resin component
- 4: conductive material
- 10: anisotropic conductive film (dispersed-type)
- 20, 30: anisotropic conductive film (aligned-type)

## Claims

1. An anisotropic conductive adhesive, comprising:
a resin component that includes a resin including a heterocycle in a main chain; and
a conductive material.

2. The anisotropic conductive adhesive according to claim 1,
wherein the resin including the heterocycle in the main chain is represented by a general formula (1) or a general formula (2) below: 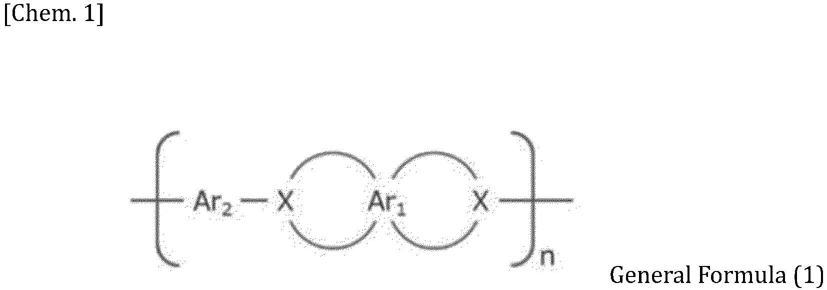
in the general formula (1), X is a group selected from the group consisting of groups below, Ar₁ and Ar₂ are each an aryl group including one or more benzene rings, and n is an integer, 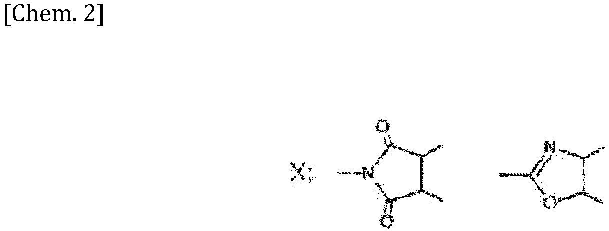 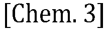 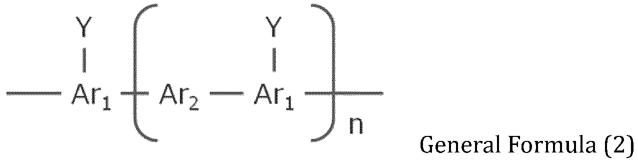
in the general formula (2), Y is a group below, Ar₁ and Ar₂ are each an aryl group including one or more benzene rings, and n is an integer

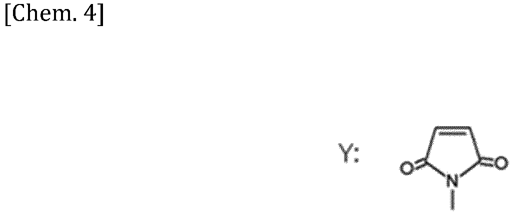

3. The anisotropic conductive adhesive according to claim 1,
wherein the resin including the heterocycle in the main chain is represented by a general formula (1) or a general formula (2) blow: 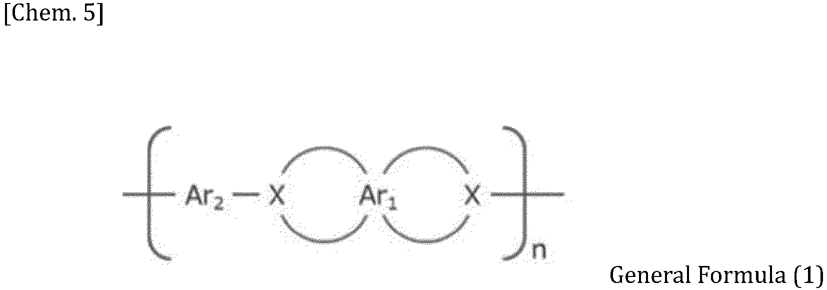
in the general formula (1), each of X, Ar₁, and Ar₂ is a group selected from the respective group consisting of groups below, and n is an integer, 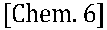 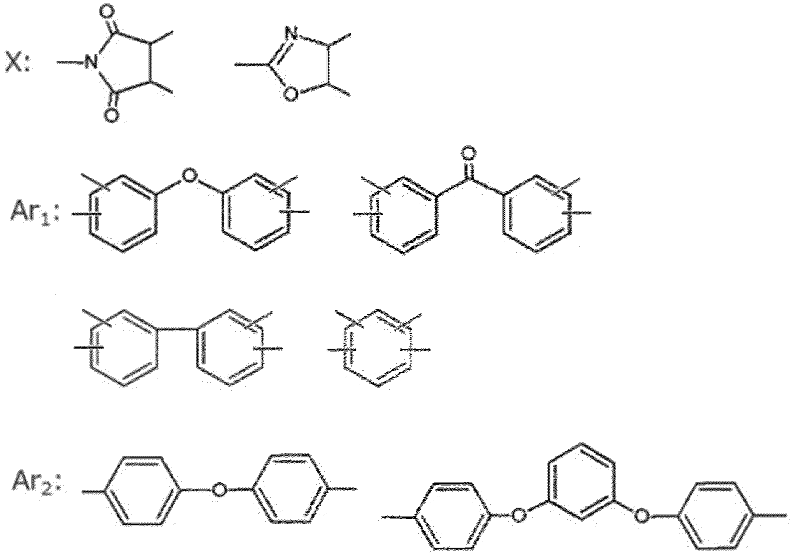 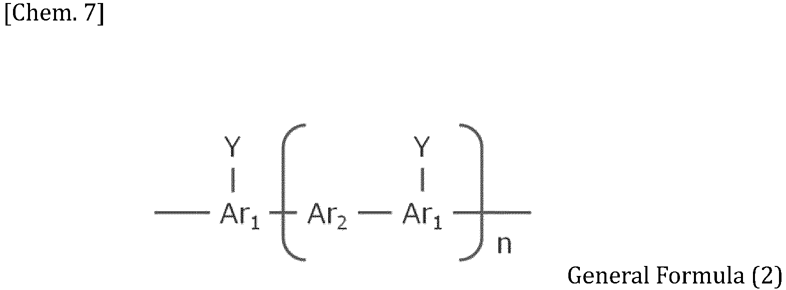
in the general formula (2), each of Y, Ar₁, and Ar₂ is a group selected from the respective group consisting of one or more groups below, and n is an integer

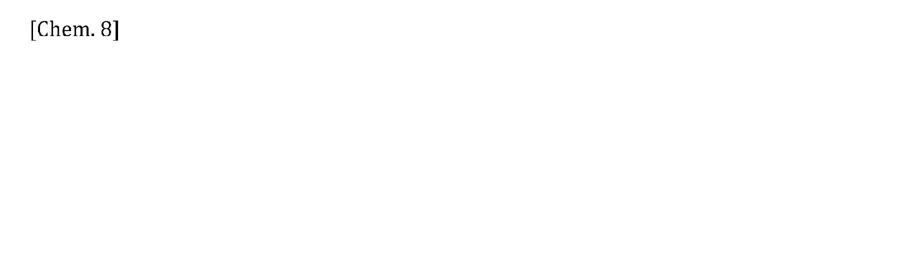

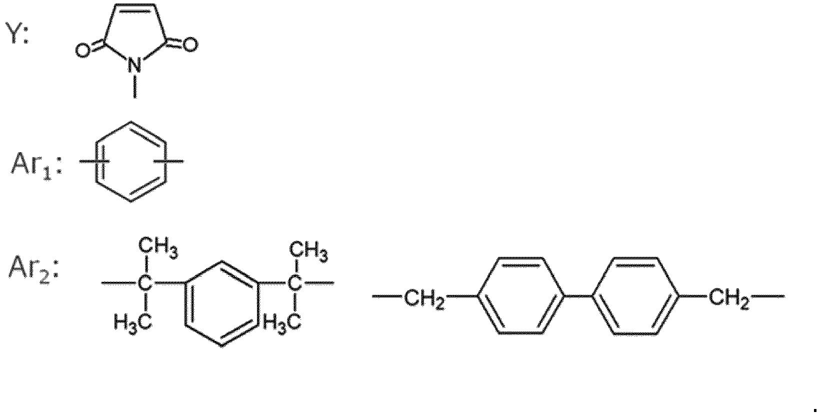

4. The anisotropic conductive adhesive according to any one of claims 1 to 3,
wherein an amount of the resin including the heterocycle in the main chain is 20 percent by mass or greater and 80 percent by mass or less relative to a total amount of the resin component.

5. The anisotropic conductive adhesive according to any one of claims 1 to 4,
wherein resistivity of the conductive material is 120 × 10⁻⁸ [Ω·m] or less.

6. The anisotropic conductive adhesive according to any one of claims 1 to 5,
wherein the conductive material includes at least one selected from the group consisting of Au, Ag, Sn, Pb, Cu, Al, Ni, and Fe.

7. The anisotropic conductive adhesive according to any one of claims 1 to 6,
wherein the conductive material includes at least one selected from the group consisting of metal particles, alloy particles, and core-shell particles.

8. The anisotropic conductive adhesive according to any one of claims 1 to 7, further comprising:
a curing agent.

9. The anisotropic conductive adhesive according to any one of claims 1 to 8, further comprising:
one or more other resins.

10. The anisotropic conductive adhesive according to any one of claims 1 to 9,
wherein the anisotropic conductive adhesive is an anisotropic conductive adhesive film.

11. The anisotropic conductive adhesive according to any one of claims 1 to 10,
wherein the anisotropic conductive adhesive is an anisotropic conductive adhesive film, in which the conductive material is aligned into a single layer within the resin component that is in a form of a film.

12. A connection structure, comprising:
a first circuit member;
a second circuit member; and
the anisotropic conductive adhesive according to any one of claims 1 to 11 that connects between the first circuit member and the second circuit member with an anisotropic conductive connection.
